# EUROPÄISCHE PATENTSCHRIFT

(11) **EP 3 196 902 B1**
(45) Veröffentlichungstag und Bekanntmachung des Hinweises auf die Patenterteilung: **24.04.2019**
(21) Anmeldenummer: 16152567.0
(22) Anmeldetag: 25.01.2016
(51) Int. Cl.: H01F 27/34, H01F 27/42, H01F 27/10, H01F 27/25, H01F 27/38, H01F 29/14, G01R 33/02

(54) **SCHALTUNGSANORDNUNG ZUR VERRINGERUNG EINES GLEICHFLUSS-ANTEILS IM WEICHMAGNETISCHEN KERN EINES TRANSFORMATORS**
CIRCUIT ASSEMBLY FOR THE REDUCTION OF A UNIDIRECTIONAL FLUX FRACTION IN THE SOFT MAGNETIC CORE OF A TRANSFORMER
CIRCUIT DE REDUCTION D'UNE PART DU FLUX CONTINU DANS LE NOYAU MAGNETIQUE DOUX D'UN TRANSFORMATEUR

(43) Veröffentlichungstag der Anmeldung: 26.07.2017
(73) Patentinhaber: Siemens Aktiengesellschaft, 80333 München (DE)
(72) Erfinder: Hamberger, Peter, 4202 Kirchschlag bei Linz (AT); Weidenholzer, Günther, 4152 Sarleinsbach (AT)
(74) Vertreter: Maier, Daniel Oliver

(56) Entgegenhaltungen:
- EP-B1- 2 622 614
- WO-A1-2008/151661
- CH-A- 403 944

## Beschreibung

### Technisches Gebiet

Die Erfindung betrifft allgemein das technische Gebiet elektrischer Transformatoren, wie sie in Netzen zur Erzeugung, Übertragung und Verteilung elektrischer Energie eingesetzt werden, insbesondere eine Schaltungsanordnung zur Verringerung eines Gleichfluss-Anteils im weichmagnetischen Kern eines Transformators.

### Stand der Technik

Es ist bekannt, dass es in Netzen zur Erzeugung, Übertragung und Verteilung elektrischer Energie aus unterschiedlichen Gründen zu einer unerwünschten Einspeisung eines Gleichstroms kommen kann, beispielsweise durch leistungselektronische Schalteinheiten im Netz. Ein solcher Gleichstrom, im Folgenden auch als DC-Anteil bezeichnet, hat einen Gleichfluss-Anteil zur Folge, der eine unsymmetrische Aussteuerung des magnetischen Kernwerkstoffs des Transformators bewirkt. Dadurch erhöhen sich Verluste und Betriebsgeräusche des Transformators. Eine andere mögliche Ursache sind so genannte "Geomagnetically Induced Currents" ("GIC"), die insbesondere für Transformatoren großer Leistung problematisch sind, da sich die Leerlaufverluste und Leerlaufgeräusche stark erhöhen. Je nach Bauart des Transformators kann schon ein sehr geringer GleichstromAnteil von einigen 100 mA die Emission von Betriebsgeräuschen um 10 bis 20 dB erhöhen. Gleichstromanteile, von bis zu 50 A, können bei "GIC" auftreten. Es kann zu einer signifikanten Erhöhung der Verluste im Bereich von 20-30 % kommen. Eine lokale Erwärmung im Transformator kann die Lebensdauer der Wicklungsisolation stark beeinträchtigen.

Zur Verringerung eines Gleichfluss-Anteils im Kern eines Transformators sind verschiedene Verfahren und Vorrichtung bekannt. Beispielsweise wird in der EP 2 622 614 B1 vorgeschlagen, mittels einer Schalteinheit in eine Kompensationswicklung, die mit dem Kern des Transformators magnetisch gekoppelt ist, einen Kompensationsstrom einzuspeisen. Die Wirkung des Kompensationsstroms ist dem störenden Gleichfluss-Anteil entgegen gerichtet. Für die Realisierung der Schalteinheit werden gesteuerte Ventile, wie beispielsweise Thyristoren vorgeschlagen. Der praktische Einsatz von gesteuerten Halbleiterschaltern ist aber aufgrund ihrer maximal zulässigen Spannung bzw. Verlustleistung derzeit auf etwa 690 V begrenzt. Bei Transformatoren, die im Rahmen einer Hochspannung-Gleichstrom-Übertragung (HGÜ) eingesetzt werden, kann aber die in der Kompensationswicklung induzierte Spannung weit über diesen Grenzwerten liegen und durchaus 8 kV überschreiten. Der praktische Einsatz von Thyristoren in diesem Hochspannungsbereich ist nicht nur begrenzt, sondern erfordert außerdem einen erheblichen Aufwand für Kühleinrichtungen zur Abfuhr der Schaltverluste. Außerdem sind zur Ansteuerung von gesteuerten Ventilen vergleichsweise komplexe Steuerschaltungen erforderlich, was für die Zuverlässigkeit ungünstig ist. Für eine praxistaugliche Gleichfluss-Kompensation gelten ähnliche Anforderungen wie für Leistungstransformatoren selbst: Die Kompensationseinrichtung soll einfach aufgebaut sein und über mehrere Jahrzehnte mit geringem Wartungsaufwand störungsfrei arbeiten.

### Darstellung der Erfindung

Es ist eine Aufgabe der vorliegenden Erfindung eine Schaltungsanordnung zur Verringerung eines Gleichfluss-Anteils im magnetischen Kern eines Transformators anzugeben, die einfach aufgebaut ist und über einen möglichst langen Betriebszeitraum zuverlässig funktioniert.

Diese Aufgabe wird durch die Merkmale des Anspruchs 1 bzw. 2 gelöst. Weitere vorteilhafte Ausgestaltungen, Aspekte und Einzelheiten der Erfindung ergeben sich aus den abhängigen Ansprüchen, der Beschreibung und der beigefügten Zeichnung.

Im Ansatz geht die vorliegende Erfindung davon aus, bei der Erzeugung eines Kompensationsstroms eine Schaltungsanordnung zu verwenden, die ohne gesteuerte Ventile auskommt.

Erfindungsgemäß weist die Schaltungsanordnung gemäß einer ersten Variante folgende Komponenten auf:
- eine Kompensationswicklung, die mit dem Kern des Transformators magnetisch gekoppelt ist;
- einen Transduktor, der in Reihe mit der Kompensationswicklung in einem Kompensations-Strompfad angeordnet ist, wobei der Kompensations-Strompfad zwei parallele Stromzweige aufweist, in denen jeweils eine Arbeitswicklung des Transduktors und ein ungesteuertes Ventil in Reihe angeordnet ist, wobei die Flussrichtung der Ventile entgegengesetzt gerichtet ist, und wobei jede Arbeitswicklung über einen sättigungsfähigen Transduktor-Kern mit einer Steuerwicklung magnetisch gekoppelt ist;
- eine Steuereinrichtung, der eingangsseitig eine Information über Größe und Richtung des Gleichfluss-Anteils zugeführt ist, und die ausgangsseitig eine Steuergröße erzeugt, die jeder Steuerwicklung zugeführt ist, so dass der Sättigungszustand des Transduktor-Kerns so änderbar ist, dass sich im Kompensations-Strompfad ein Kompensationsstrom ausbildet, dessen Wirkung dem Gleichfluss-Anteil entgegen gerichtet ist.

Gemäß einer zweiten Variante umfasst die Erfindung folgende Merkmale:
- eine Kompensationswicklung, die mit dem Kern des Transformators magnetisch gekoppelt ist;
- einen Transduktor, mit einer Arbeitswicklung, die in Reihe mit der Kompensationswicklung in einem Kompensations-Strompfad angeordnet ist, wobei im Kompensations-Strompfad ein ungesteuertes Ventil und eine Schaltvorrichtung zum Umpolen der Stromflussrichtung im Ventil angeordnet ist, und wobei die Arbeitswicklung über einen sättigungsfähigen Transduktor-Kern mit einer Steuerwicklung magnetisch gekoppelt ist;
- eine Steuereinrichtung, der eingangsseitig eine von einer Erfassungseinrichtung bereitgestellte Information über Größe und Richtung des Gleichfluss-Anteils (Φ_{DC}) zugeführt ist, und die ausgangsseitig eine Steuergröße erzeugt, die der Steuerwicklung zugeführt ist, so dass der Sättigungszustand des Transduktor-Kerns so änderbar ist, dass im Kompensations-Strompfad ein Kompensationsstrom (I_{K}) sich ausbildet, dessen Wirkung im Kern des Transformators dem Gleichfluss-Anteil (Φ_{DC}) entgegen gerichtet ist.

Durch die Verwendung eines Transduktors in Verbindung mit ungesteuerten Ventilen entfällt die sonst für gesteuerte Ventils erforderliche komplexe Steuerschaltung. Verglichen mit einem Thyristor, sind ungesteuerte Ventile, wie beispielsweise eine Diode, vergleichsweise robust und haben eine höhere Lebensdauer. Der Transduktor, der im Wesentlichen aus einem magnetischen Kern und einer darauf angeordneten Wicklungsanordnung (bestehend aus einer oder einer paarweisen Anordnung von Arbeitswicklung und Steuerwicklung) besteht, ähnelt von seiner Bauweise einem Transformator und lässt eine ähnlich hohe Lebensdauer erwarten.

Besonders gering ist der Aufwand der Realisierung gemäß Variante zwei. Eine komplexe Steuerschaltung, wie sie zur elektronischen Ansteuerung gesteuerter Ventile erforderlich ist, entfällt. Die Schaltvorrichtung zum Umpolung des einzigen ungesteuerten Ventils (Diode) kann mechanisch ausgeführt sein und von einem Antrieb betätigt werden.

Was die elektrischen Durchlassverluste anbelangt, sind die einer Diode im Vergleich zu den Schaltverlusten eines gesteuerten Ventils vergleichsweise gering, so dass der Aufwand für die Kühlung insgesamt viel gering ist. Im Vergleich zu gesteuerten Ventilen, wie Thyristoren, liegen die Grenzwerte hinsichtlich zulässiger Spannung und Verlustleistung für derzeit kommerziell verfügbare Dioden vergleichsweise höher. Dadurch ist der Einsatz einer DC-Kompensationseinrichtung nicht mehr auf Niederspannungen begrenzt, sondern nunmehr auch für Hochspannungen für große Leistungstransformatoren, wie beispielsweise HGÜ-Transformatoren möglich. Die Realisierung kann kostengünstig durchgeführt werden.

Die erfindungsgemäß verwendeten Komponenten sind für beide Varianten vergleichsweise einfach und lassen insgesamt einen langjährigen störungsfreien Betrieb erwarten.

Bevorzugt ist jeweils eine Ausführung, bei der das ungesteuerte Ventil bzw. die beiden ungesteuerten Ventile jeweils als hochsperrende Leistungsdioden ausgeführt werden.

Hinsichtlich geringer Herstellungskosten kann es günstig sein, wenn die Schaltungsanordnung einen Transduktor aufweist, dessen Transduktor-Kern als Spaltbandkern oder in Form von geschichteten Blechlamellen ausgebildet ist.

Eine geringe Verlustleistung im magnetischen Werkstoff des Transduktors lässt sich dadurch erreichen, indem dieser aus einzelnen Blechlamellen zusammengesetzt ist und dabei für die Bleche ein Magnetwerkstoff verwendet wird, der eine möglichst schmale rechteckförmige Hystereseschleife aufweist. Damit ist die Ansteuerleistung für den Transduktor gering, wodurch die steuernde Baueinheit einfacher aufgebaut werden kann.

Eine weitere Vereinfachung der steuernden Baueinheit kann dadurch erreicht werden, wenn der Transduktor-Kern in einem magnetischen Kreis angeordnet ist, der zumindest einen Luftspalt aufweist, so dass die Remanenz-Flussdichte auf kleiner oder gleich 20 % der Sättigungsflussdichte begrenzt ist.

Für eine noch weitergehende Verringerung der Verluste in der steuerenden Einheit kann es vorteilhaft sein, wenn ein verlustarmes kornorientiertes Elektroblech, ein so genannter HiB-GOES-Blechwerkstoff verwendet wird.

Ein ganz besonders verlustarmer Betrieb des Transduktors kann erreicht werden, wenn im weichmagnetischen Transduktor-Kern der magnetische Fluss in Richtung der Walzrichtung des Elektroblechs geführt ist.

Um den Strom im Kompensations-Strompfad zu begrenzen kann eine Strombegrenzungsdrossel verwendet werden, beispielsweise in Reihe zwischen Transduktor und Kompensationswicklung.

In einer bevorzugten Ausführungsform der Schaltvorrichtung kann vorgesehen sein, dass die Arbeitswicklung(en) des Transduktors mit einer genügend großen Streuinduktivität so ausgebildet ist, dass sie gleichzeitig auch zur Strombegrenzung dient. Die Arbeitswicklung(en) fungiert dann gleichzeitig als Strombegrenzungsdrossel, sodass diese als separates Bauteil wegfällt.

In beiden Fällen ist sichergestellt, dass im Strompfad der maximale Strom auch dann begrenzt wird, wenn die Steuereinrichtung des Transduktors versagt. Die in der Steuereinrichtung sonst vorzusehenden Maßnahmen zur Strombegrenzung können einfacher ausgeführt werden bzw. ganz entfallen.

Für eine hohe Zuverlässigkeit und lange Betriebsdauer kann es vorteilhaft sein, wenn die im Leistungsstrang angeordneten Baukomponenten, d.h. die Kompensationswicklung, der Transduktor, die Ventile und gegebenenfalls die Strombegrenzungsdrossel im Inneren eines Transformatorkessels angeordnet sind. Dadurch werden diese Baukomponenten der Schaltungsanordnung von der Isolations- und Kühlflüssigkeit des Transformators umspült und gekühlt, was für deren Lebensdauer günstig ist.

Zur Erzeugung des Kompensationsstroms kann es vorteilhaft sein, wenn mittels einer Messeinrichtung die Phasenlage der in der Kompensationswicklung induzierten Spannung erfasst und der Steuereinrichtung zugeführt ist. Dadurch vereinfacht sich die Erzeugung des Kompensationsstroms.

Eine Information über Größe und Richtung des zu kompensierenden Gleichfluss-Anteils kann beispielsweise mittels einer am Kern des Transformators angeordneten Messeinrichtung erfasst werden. Eine solche Messeinrichtung kann beispielsweise ein magnetischer Sensor sein, der im Nebenschluss am Joch des Transformators oder an einem Schenkel angeordnet ist.

Eine andere Möglichkeit eine Information über Größe und Richtung des Gleichfluss Anteils bereitzustellen kann aber auch aus dem Energieversorgungsnetz selbst gewonnen werden. Die Information kann beispielsweise an Anschlussleitungen des Transformators messtechnisch ermittelt werden. Zur Detektion eines DC-Anteils im Netz stehen dem Fachmann verschiedene Einrichtungen zur Verfügung.

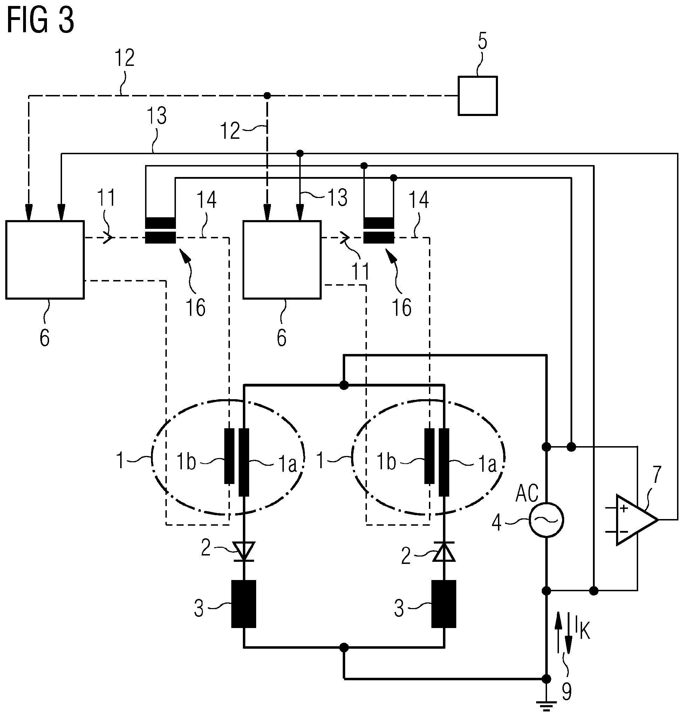

In einer ganz besonders bevorzugten Ausführung kann vorgesehen sein, dass für jeden Steuerkreis ein Transformator jeweils mit einer Primärwicklung und einer Sekundärwicklung vorgesehen ist (Figur 3), wobei jede Primärwicklung von der Kompensationswicklung gespeist ist, und wobei jede Sekundärwicklung einem Steuerkreis zugeordnet und dort so eingebunden ist, dass die in der jeweiligen Steuerwicklung (1b) induzierte Spannung kompensiert ist. Dadurch ist das benötigte Einbauvolumen für die erfindungsgemäße Schaltungsanordnung gering und eine sehr differenzierte Kompensation eines störenden DC-Anteils möglich.

### Kurzbeschreibung der Zeichnung

Zur weiteren Erläuterung der Erfindung wird im nachfolgenden Teil der Beschreibung auf Zeichnungen Bezug genommen, aus denen weitere vorteilhafte Ausgestaltungen, Einzelheiten und Weiterbildungen der Erfindung anhand eines nicht einschränkenden Ausführungsbeispiels zu entnehmen sind. Es zeigen:
- Figur 1: eine erste Variante der Schaltungsanordnung gemäß der Erfindung in einer schematischen Darstellung;
- Figur 2: eine zweite Variante der Schaltungsanordnung gemäß der Erfindung in einer schematische Darstellung;
- Figur 3: eine bevorzugte Ausführung gemäß der ersten Variante der Erfindung in einer schematischen Darstellung.

### Ausführung der Erfindung

Im Folgenden wird die Erfindung beispielhaft anhand von Ausführungsbeispielen näher erläutert.

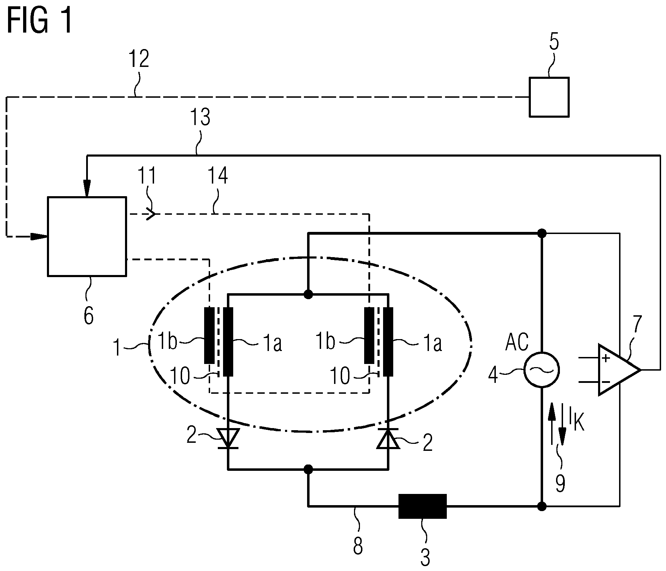

Figur 1 zeigt eine schematische Darstellung einer ersten Variante der erfindungsgemäßen Schaltungsanordnung. Mit dem Bezugszeichen 4 ist eine Kompensationswicklung bezeichnet, die mit dem weichmagnetischen Kern eines Transformators magnetisch gekoppelt ist. (Der Übersichtlichkeit wegen sind in den Zeichnungen weder der magnetische Kern noch die übrigen an sich bekannten Bauteile des Transformators zeichnerisch dargestellt.)

Wie aus der Figur 1 zu sehen ist, ist die Kompensationswicklung 4 in einen Kompensations-Strompfad 8 eingebunden. Der Kompensations-Strompfad 8, im Folgenden auch Leistungsstrang genannt (in den Figuren 1 bis 3 in einer breiten Strichstärke dargestellt) spaltet sich in der in Figur 1 dargestellten Variante der Erfindung in zwei parallele Zweige auf: In jedem dieser Parallelzweig liegt eine Arbeitswicklung 1a eines Transduktors 1. Jeweils in Reihe zu einer Arbeitswicklung 1a liegt ein Ventil 2. Jedes dieser Ventile 2 ist ungesteuert. Die Ventile 2 sind als Halbleiter-Dioden ausgeführt. In den beiden parallelen Zweigen sind die Dioden 2 antiparallel geschaltet, das heißt, in Umlaufrichtung des Kompensations-Strompfades 8 gesehen zeigt die Flussrichtung der einen Diode 2 (in Figur 1 die linke Diode) entgegen dem Uhrzeigersinn, die andere Diode 2, die im rechten Parallelzweig angeordnet ist, zeigt mit ihrer Durchlassrichtung in Richtung des Uhrzeigersinns.

Wie aus Figur 1 zu entnehmen ist, weist der Transduktor 1 zwei Arbeitswicklung 1a und zwei Steuerwicklungen 1b auf. Jeder Arbeitswicklung 1a in einem Parallelzweig ist jeweils eine Steuerwicklung 1b zugeordnet. Jede der beiden Arbeitswicklungen 1a führt einen Teil des Kompensationsstroms I_{K}. Die magnetische Kopplung zwischen einer Arbeitswicklung 1a und der ihr zugeordneten Steuerwicklung 1b stellt jeweils ein weichmagnetischer Transduktor-Kern 10 her (in Figur 1 vereinfacht als unterbrochen Linie gezeichnet). Der Transduktor-Kern 10 ist ein Spaltbandkern, kann aber auch lamellenartig aufgebaut sein. Der Werkstoff für diesen Transduktor-Kern 10 ist ein kornorientiertes Elektroblech HiB GOES. Die Hysterese dieses Blechwerkstoffs ist eine schmale Rechteckkurve, so dass wenig Schaltleistung zur Ansteuerung des Transduktors 1 benötigt wird. Der magnetische Fluss ist im Transduktor-Kern 10 in Walzrichtung des Elektroblechs geführt.

Die beiden Steuerwicklungen 1b sind in einem Steuerkreis 14 in Serie hintereinander angeordnet. Eine Steuereinrichtung 6 speist in diesen Steuerkreis 14 eine Steuergröße 11 ein. Wie unten stehend näher ausgeführt, bewirkt diese Steuergröße 11 eine unterschiedliche Sättigung des magnetischen Werkstoffs des Transduktor-Kerns 10, wodurch im Kompensations-Strompfad 8 ein Strom mit einem Gleichstromanteil sich ausbildet. Der Gleichstromanteil ist dabei in Größe und Richtung durch die Steuergröße 11 so vorgebbar, dass dem störenden Gleichfluss-Anteil Φ_{DC} (der von einem DC-Anteil in den Primär- / Sekundärwicklungen des Transformators herrührt) zumindest entgegengewirkt wird, bzw. dieser im Idealfall vollständig kompensiert wird.

### Eingangsseitig sind in Figur 1 der Steuereinrichtung 6 zwei Signale zugeführt:

Zum einen eine Information 12 über Größe und Richtung des zu kompensierenden Gleichfluss-Anteils Φ_{DC}. Diese Information über den störenden Gleichfluss-Anteil Φ_{DC} kann - wie in Figur 1 dargestellt - das Signal einer Erfassungseinrichtung 5 sein, die beispielsweise am Joch des Transformators den Gleichfluss-Anteil Φ_{DC} detektiert. Geeignet ist insbesondere ein in PCT/EP 2010/054857 beschriebenes Bypass-Messprinzip, welches im Wesentlichen aus einem magnetischen Nebenschluss-Teil besteht, der am Kern des Transformators so angeordnet ist, dass ein Anteil des magnetischen Flusses abgezweigt und in einem Nebenschluss geführt wird, so dass mit einer am Nebenschluss-Teil angeordneten Sensorspule ein dem Gleichfluss-Anteil Φ_{DC} entsprechendes Messsignal ermittelt werden kann. Ein solcher Magnetfeldsensor ist im Kessel des Transformators angeordnet.

Die Information zur Verringerung der Auswirkungen eines Gleichfluss-Anteils Φ_{DC} kann aber auch von woanders her stammen, zum Beispiel aus dem Energieversorgungsnetz selbst, in welchem der GIC-Gleichstromanteil in Netzleitern des Energieversorgungsnetzes gemessen wird - was technisch aufwendig ist -, bzw. ein "GIC" auf andere Weise prognostiziert bzw. erfasst wird. In der schematischen Darstellung der Figur 1 ist der Einfachheit wegen dies alles nicht dargestellt; mit dem Funktionsblock 5 ist allgemein eine Erfassungseinrichtung gezeichnet, die eingangsseitig der Steuereinheit 6 über den Messsignalpfad 12 die relevante Information über Richtung und Größe der zu kompensierenden Störgröße bereitstellt.

Zum anderen ist in Figur 1 noch ein weiteres Signal 13 dargestellt, welches von einem Detektor 7 stammt, der die Phasenlage der in der Kompensationswicklung 4 induzierten Wechselspannung angibt. In der Ausführung der Figur 1 wird dieses Signal 13 bei der Erzeugung der Steuergröße 11 ebenfalls mit verwendet, wodurch der Aufwand in der Steuereinheit 6 gering gehalten werden kann.

In Abhängigkeit dieser beiden Eingangsgrößen 12 und 13 erzeugt in diesem Beispiel die Steuereinheit 6 das Steuersignal 11. Dieses Steuersignal wird in den Steuerkreis 14 eingespeist. Die Steuereinheit 6 steuert also gezielt den Sättigungszustand im Transduktor 1 an, wodurch dessen Schaltverhalten vorgegeben wird. Die Anzahl der Ausgänge der Steuereinheit 6 richtet sich nach der Ausbildung des Transduktors 1. Die Steuereinheit 6 beinhaltet einen Computer, der im vorliegenden Ausführungsbeispiel auch die Funktionalität eines adaptiven Reglers umfasst, wodurch eine Kalibrierung in einem kostenaufwändigen Prüffeld weitgehend entfällt. Die Erzeugung des Steuersignals 11 erfolgt durch geeignete Algorithmen in der Steuereinrichtung 6. Durch die Verwendung der Information 13 über die Phasenlage, kann der Algorithmus zum Erzeugen der Steuergröße 11 in der Steuereinrichtung 6 einfacher ausgeführt werden, das Signal 13 ist aber grundsätzlich nicht zwingend erforderlich.

Der Transduktor 1 wird durch einen Stromimpuls in dessen Steuerwicklung 1b zwischen einem sperrenden in einem leitenden Zustand geschaltet. Der Transduktor 1 hält sich selbst über den Strom in der Arbeitswicklung 1a bis zu dessen Nulldurchgang leitend und geht dann automatisch in den sperrenden Zustand über. Damit entspricht das Schaltverhalten dieses "magnetischen Schalters" dem eines gesteuerten Ventils, weist aber nicht dessen Nachteile auf. Im Ergebnis beeinflusst das Steuersignal 11 den Sättigungszustand des Transduktor-Kerns 10 so, dass sich im Kompensations-Strompfad 8 ein in Größe und Richtung vorgebbarer Kompensationsstrom I_{K} einstellt. In Figur 1 ist dies durch den Doppelpfeil 9 angedeutet.

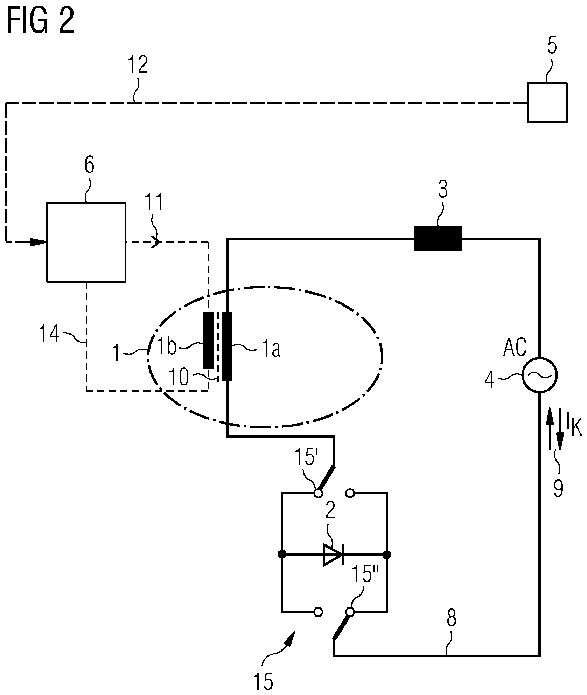

Figur 2 zeigt eine zweite Variante der erfindungsgemäßen Schaltungsanordnung. Im Unterschied zur Ausführung gemäß Figur 1 besteht der Transduktor 1 aus nur einer Arbeits- und Steuerwicklung 1a, 1b; darüber hinaus ist im Leistungspfad 8 (Kompensations-Strompfad) nicht eine antiparallele Anordnung von zwei Ventilen 2 angeordnet, sondern nur ein einziges Ventil 2, welches mittels einer Schaltvorrichtung 15 im Strompfad 8 umgepolt werden kann. Die Schaltvorrichtung 15 zur Umpolung der Diode 2 ist hier als mechanischer Schalter ausgeführt, der aus zwei Schaltkontakten 15' und 15" besteht. Die Schaltkontakte 15' und 15" werden von einer nicht näher dargestellten Antriebseinheit betätigt, z.B. durch eine elektrischen Antrieb. In der Schaltkonstellation der Figur 2 sind die beiden Schaltkontakte 15' und 15" in einer Schaltstellung gezeichnet, in welcher der Kompensationsstrom I_{K} im Kompensations-Strompfad 8 entgegen dem Uhrzeigersinn fließt. Werden die beiden Schaltkontakte 15' und 15" in ihre jeweils andere Schaltstellung gebracht, d.h. der erste Schaltkontakt 15' mit der Katode, der zweite Schaltkontakt 15" mit der Anode der Diode 2 verbunden, dann ändert sich die Stromrichtung des Kompensationsstroms I_{K} im Kompensations-Strompfad 8. Der Kompensationsstrom I_{K} fließt im dargestellten Schaltplan der Figur 2 nun in entgegengesetzte Richtung, das heißt in Richtung des Uhrzeigersinns. Wie in den Erläuterungen zu Figur 1 oben bereits ausgeführt, wird der magnetische Gleichfluss-Anteil im Kern eines Transformators mittels des "magnetischen Schalters" 1 verringert. Der Transduktor 1 wird im Steuerstrang 14 von einer Steuerung 6 durch das Steuersignal 11 wieder so gesteuert, dass im Leistungsstrang 8 ein bidirektionaler Kompensationsstroms I_{K} (Doppelpfeil 9) zu fließen kommt. Die Information über die zu kompensierende Störung wird über den Signalpfad 12 der Steuereinheit 6 zugeleitet. Der Kompensationsstrom I_{K} ist so geartet, dass er die unerwünschte Auswirkung des Gleichfluss-Anteils Φ_{DC} im Kern des Transformators verringert. Folge davon ist, dass die unsymmetrische magnetische Aussteuerung und damit auch Verlustleistung und Geräuschemission des Transformators sich verringern. Eine geringere Verlustleistung, d.h. geringer Betriebstemperatur begünstigt die Lebensdauer des Transformators.

Der Vorteil der in Figur 2 gezeigten Schaltungsvariante liegt in erster Linie in der Kompensation größerer Kompensationsleistungen, die größere Transduktoren und Strombegrenzungsdrosseln benötigen. Hier kann es sinnvoll sein, durch Umpolung des (einzigen) ungesteuerten Gleichrichters 2 auf die geänderte Polarität des Gleichstroms zu reagieren. Im Vergleich zu Figur 1 ist der Schaltungsaufwand auch geringer. Man muss nur einen Transduktor vorsehen, statt zwei Transduktor-Spulen pro Polarität des zu kompensierenden Gleichstroms. Hierbei kann es im Sinne einer hohen Verfügbarkeit und Betriebssicherheit günstig sein, die Schaltvorrichtung 15 als mechanischen Schalter auszuführen. Dies ist für eine hohe Verfügbarkeit und Betriebssicherheit günstig. Erfahrungsgemäß ändert sich die Polarität eines zu kompensierenden Gleichstroms, zum Beispiel eines "GIC" nur sehr langsam. Daher kann der mechanische Schalter 15 durch einen einfachen Mechanismus betätigt werden. Die räumliche Anordnung dieses Schalters 15 ist bevorzugt im Kesselinneren, so dass dessen Schaltkontakte 15', 15" von der im Kesselinneren befindlichen Isolations- und Kühlflüssigkeit umspült sind.

Figur 3 zeigt eine bevorzugte Ausführung der ersten Variante der Erfindung. Im Unterschied zu Figur 1 werden zwei komplett getrennte Transduktoren 1 eingesetzt, die auch getrennt je nach Polarität des zu kompensierenden Gleichstroms (GIC) von Steuereinheiten 6 angesprochen werden können. Jede Steuerwicklung 1b wird wieder durch ein Steuersignal 11 im Steuerkreis 14 gesteuert. Das Steuersignal 11 stellt jeweils eine Steuereinheit 6 bereit. In jedem der beiden Steuerkreise 14 zur Ansteuerung der Steuerwicklingen 1b ist jeweils eine Wicklung eines Transformators 16 so eingebunden, dass in den Steuerwicklungen 1b induzierte Spannungen kompensiert werden. Dies hat den Vorteil, dass die benötigte Steuerleistung wesentlich reduziert wird. Die beiden Steuereinheiten 6 können dadurch einfacher aufgebaut werden. Die beiden Transformatoren 16 sind zudem so ausgeführt, dass in den jeweiligen Steuerkreisen 14 jeweils eine Streuinduktivität eingebracht wird, wodurch sich die Stabilität des jeweiligen Reglers 6 erhöht. Als weiterer Unterschied zu Figur 1 ist in der Ausführung der Figur 3 die Strombegrenzungsdrossel 3 getrennt in jedem Parallelzweig verbaut. Dies hat den Vorteil, dass sich der erforderliche Einbauraum für die Strombegrenzungsdrossel 3 weiter verringert. Es ist aber auch bei der in Figur 3 dargestellten Ausführung möglich, die Drossel 3 in die Arbeitswicklung 1a so zu integrieren, so dass eine genügend große Streuinduktivität erreicht wird. Dann ist eine separate Strombegrenzung nicht mehr erforderlich. Die Realisierung der erfindungsgemäßen Schaltungsanordnung ist dann besonders günstig.

### Zusammenfassend ergeben sich folgende Vorteile:

Der Transduktor bildet in Verbindung mit ungesteuerten Ventilen eine robuste Baueinheit, die zuverlässig über einen langen Betriebszeitraum funktioniert.
Die Anordnung von Transduktor und Diode innerhalb des Kessels eines Transformators hat den Vorteil, dass eine effiziente Kühlung möglich ist. Es entfällt eine aufwändige Kühlvorrichtung. Ebenso entfällt ein aufwändiger Schaltschrank samt darin befindlicher Leistungselektronik.

Der komplette Leistungsstrang 8, d.h. die im Kompensations-Strompfad angeordneten Baukomponenten können innerhalb des Transformatorkessels untergebracht werden. Die Problematik mit Erdschlüssen in der äußeren Leitungsführung des Leistungsstrangs fällt weg. Ebenso entfallen Durchführungen, die sonst für das Herausführen des Leistungsstrangs erforderlich wären. Auch Einrichtungen zum Abtrennen des Leistungsstrangs, wie Sicherung oder Schütz, sind nicht erforderlich.

Die magnetisch wirkende Schaltervorrichtung, bestehend aus Transduktor und Diode, ist leicht für verschiedene Spannungen und Leistungen skalierbar. Auch bei vergleichsweise hohen Spannungen und Leistungen ist eine kostengünstige DC-Kompensation realisierbar. Damit ist auch der Einsatz einer DC-Kompensation bei großen HGÜ-Transformatoren nunmehr möglich.

Da die Steuereinheit außerhalb des Kessels verbleibt, ist diese kostengünstig im Rahmen der Niederspannungsrichtlinie realisierbar.

Im Falle eines Ausfalls einer Diode ist es nicht erforderlich, dass der Transformator von Netz heruntergefahren werden muss.

Die Energie für die Erzeugung dieses Kompensationsstroms I_{K} stammt dabei von der in der Kompensationswicklung 4 induzierten Spannung selbst (in Figur 1 ist die Kompensationswicklung 4 durch das Symbol einer Wechselspannungsquelle dargestellt). Die Kompensationswicklung 4 fungiert damit als Energiequelle. Eine separate Energiequelle für die Erzeugung des Kompensationsstroms I_{K} ist nicht erforderlich. Wie in Figur 1 dargestellt, fließt der Kompensationsstrom I_{K} in beiden Richtungen durch die Kompensationswicklung 4, was zur Folge hat, dass der mit ihm einhergehende magnetische Flussanteil dem störenden Gleichfluss-Anteil Φ_{DC} im Kern des Transformators - je nach dessen Richtung - entgegenwirkt. In Figur 1 ist der bidirektionale Kompensationsstroms I_{K} durch ein gegenläufiges Pfeilpaar 9 angedeutet.

In den Figuren 1 bzw. 2 ist jedes ungesteuerte Ventil 2 als eine hochsperrende Leistungsdiode ausgebildet, die eine hohe Sperrfähigkeit und einen niedrigen Durchlasswiderstand aufweist. Halbleitertechnisch wird dies dadurch erreicht, indem zwischen hochdotierten pn-Zonen eine dünne niedrig dotierte Zwischenschicht eingefügt ist. Dadurch sind die Verluste in diesem (nicht gesteuerten) Ventil verglichen mit einem Thyristor geringer.

Obwohl die Erfindung anhand der oben dargestellten Ausführungsbeispiele näher beschrieben und erläutert wurde, so ist die Erfindung auf diese Beispiele nicht eingeschränkt. Andere Ausgestaltungen und Variationen sind denkbar, ohne dass der Grundgedanke der Erfindung verlassen wird.

Der Transduktor 1, dessen Bauweise an sich bekannt ist, kann hinsichtlich seines Kernaufbaus unterschiedlich aufgebaut sein, beispielsweise aus zwei getrennten Magnetkreisen bestehen oder aus einem Magnetkern mit drei Schenkeln. Sein Wicklungsaufbau kann aus zwei getrennt gewickelten Steuerspulen 1a je Leistungsstrang 1a bestehen, oder aus einer gemeinsamen Steuerspule 1b für beide Leistungsstränge 1a.

In der Blockdarstellung der Figur 1 und 2 ist im Kompensations-Strompfad 8 eine Strombegrenzungsdrossel 3 zu sehen. Wie bereits oben dargestellt, ist diese nicht zwingend erforderlich, es kann diese Funktion der Strombegrenzung auch durch eine geeignete Ausbildung der Arbeitswicklung(en) 1a des Transduktors bewerkstelligt werden. In diesem Fall würde die in Figur 1 und 2 separat dargestellte Strombegrenzungsdrossel 3 wegfallen.

### Zusammenstellung der verwendeten Bezugszeichen

- 1: Transduktor
- 1a: Arbeitswicklung
- 1b: Steuerwicklung
- 2: ungesteuertes Ventil, Diode
- 3: Strombegrenzungsdrossel
- 4: Kompensationswicklung, Spannungsquelle
- 5: Erfassungseinrichtung, Messeinrichtung
- 6: Steuereinheit
- 7: Phasendetektor
- 8: Kompensations-Strompfad
- 9: Doppelpfeil
- 10: Transduktor-Kern
- 11: Steuergröße
- 12: Signal, Messsignalpfad
- 13: Signal
- 14: Steuerkreis
- 15: Schaltvorrichtung
- 15': erster Schaltkontakt der Schaltvorrichtung 15
- 15": zweiter Schaltkontakt der Schaltvorrichtung 15
- 16: Transformator im Steuerkreis 14

- Φ_{DC}: Gleichfluss-Anteil
- I_{K}: Kompensationsstrom

## Patentansprüche

1. Schaltungsanordnung zur Verringerung eines Gleichfluss-Anteils (Φ_{DC}) im weichmagnetischen Kern eines Transformators, umfassend:
- eine Kompensationswicklung (4), die mit dem Kern des Transformators magnetisch gekoppelt ist;
- einen Transduktor (1), der in Reihe mit der Kompensationswicklung (4) in einem Kompensations-Strompfad (8) angeordnet ist, wobei der Kompensations-Strompfad (8) zwei parallele Stromzweige aufweist, in denen jeweils eine Arbeitswicklung (1a) des Transduktors (1) und ein ungesteuertes Ventil (2) in Reihenschaltung angeordnet ist, wobei die Flussrichtung der Ventile (2) entgegengesetzt gerichtet ist, und wobei jede Arbeitswicklung (1a) über einen sättigungsfähigen Transduktor-Kern (10) mit einer Steuerwicklung (1b) magnetisch gekoppelt ist;
- eine Steuereinrichtung (6), der eingangsseitig eine von einer Erfassungseinrichtung (5) bereitgestellte Information (12) über Größe und Richtung des Gleichfluss-Anteils (Φ_{DC}) zugeführt ist, und die ausgangsseitig eine Steuergröße (11) erzeugt, die jeder Steuerwicklung (1b) zugeführt ist, so dass der Sättigungszustand des Transduktor-Kerns (10) so änderbar ist, dass im Kompensations-Strompfad (8) ein Kompensationsstrom sich ausbildet, dessen Wirkung im Kern des Transformators dem Gleichfluss-Anteil (Φ_{DC}) entgegen gerichtet ist.

2. Schaltungsanordnung zur Kompensation eines Gleichfluss-Anteils (Φ_{DC}) im weichmagnetischen Kern eines Transformators, umfassend:
- eine Kompensationswicklung (4), die mit dem Kern des Transformators magnetisch gekoppelt ist;
- einen Transduktor (1), mit einer Arbeitswicklung (la), die in Reihe mit der Kompensationswicklung (4) in einem Kompensations-Strompfad (8) angeordnet ist, wobei im Kompensations-Strompfad (8) ein ungesteuertes Ventil (2) und eine Schaltvorrichtung (15) zum Umpolen der Stromflussrichtung im Ventil (2) angeordnet ist, und wobei die Arbeitswicklung (1a) über einen sättigungsfähigen Transduktor-Kern (10) mit einer Steuerwicklung (1b) magnetisch gekoppelt ist;
- eine Steuereinrichtung (6), der eingangsseitig eine von einer Erfassungseinrichtung (5) bereitgestellte Information (12) über Größe und Richtung des Gleichfluss-Anteils (Φ_{DC}) zugeführt ist, und die ausgangsseitig eine Steuergröße (11) erzeugt, die der Steuerwicklung (1b) zugeführt ist, so dass der Sättigungszustand des Transduktor-Kerns (10) so änderbar ist, dass im Kompensations-Strompfad (8) ein Kompensationsstrom (I_{K}) sich ausbildet, dessen Wirkung im Kern des Transformators dem Gleichfluss-Anteil (Φ_{DC}) entgegen gerichtet ist.

3. Schaltungsanordnung nach Anspruch 1 oder 2, **dadurch gekennzeichnet, dass** das oder jedes Ventil (2) als hochsperrende Leistungsdiode ausgebildet ist.

4. Schaltungsanordnung nach einem der Ansprüche 1 oder 2, **dadurch gekennzeichnet, dass** der Transduktor-Kern (10) als Spaltbandkern (10) oder als geschichteter Kern ausgebildet ist.

5. Schaltungsanordnung nach Anspruch 4, **dadurch gekennzeichnet, dass** der Spaltbandkern (10) oder der geschichtete Kern aus Blechlamellen eines weich magnetischen Werkstoffs hergestellt ist, der eine im Wesentlichen schmale, rechteckförmige Hystereseschleife aufweist.

6. Schaltungsanordnung nach Anspruch 4 oder 5, **dadurch gekennzeichnet, dass** der Transduktor-Kern (10) in einem magnetische Kreis angeordnet ist, der zumindest eine Luftspalt aufweist, so dass die Remanenz-Flussdichte auf kleiner oder gleich 20 % der Sättigungsflussdichte begrenzt ist.

7. Schaltungsanordnung nach Anspruch 6, **dadurch gekennzeichnet, dass** der Werkstoff kornorientiertes Elektroblech HiB-GOES ist.

8. Schaltungsanordnung nach Anspruch 7, **dadurch gekennzeichnet, dass** der magnetische Fluss im Werkstoff in Walzrichtung des kornorientiertes Elektroblech HiB-GOES geführt ist.

9. Schaltungsanordnung nach Anspruch 1, **dadurch gekennzeichnet, dass** im Kompensations-Strompfad (8) in Reihe zwischen Transduktor (1) und Kompensationswicklung (4) zumindest eine Strombegrenzungsdrossel (3) angeordnet ist, oder die Arbeitswicklung 1 zur Strombegrenzung ausgebildet ist.

10. Schaltungsanordnung nach einem der Ansprüche 1 bis 8, **dadurch gekennzeichnet, dass** die Kompensationswicklung (4), der Transduktor (1), die Ventile (2) und ggf. die Strombegrenzungsdrossel (3) im Inneren eines mit einer Isolations- und Kühlflüssigkeit gefüllten Kessels eines Transformators angeordnet sind.

11. Schaltungsanordnung nach einem der Ansprüche 1 bis 8, **dadurch gekennzeichnet, dass** mittels einer Messeinrichtung (7) die Phasenlage der in der Kompensationswicklung (4) induzierten Spannung erfasst und der Steuereinrichtung (6) zugeführt ist.

12. Schaltungsanordnung nach einem der Ansprüche 1 bis 8, **dadurch gekennzeichnet, dass** die Information über Größe und Richtung des Gleichfluss-Anteils (Φ_{DC}) mittels einer am Kern des Transformators angeordneten Messeinrichtung (5) erfasst wird.

13. Schaltungsanordnung nach einem der Ansprüche 1 bis 8, **dadurch gekennzeichnet, dass** die Information über Größe und Richtung des Gleichfluss-Anteils (Φ_{DC}) mittels einer an Anschlussleitungen des Transformators angeordneten Messeinrichtung (5) erfasst wird.

14. Schaltungsanordnung nach Anspruch 1, **dadurch gekennzeichnet, dass** für jeden Steuerkreis (14) ein Transformator (16) vorgesehen ist, der jeweils mit eine Primärwicklung und eine Sekundärwicklung aufweist, wobei jede Primärwicklung von der Kompensationswicklung (4) gespeist ist, und wobei jede Sekundärwicklung jeweils einem Steuerkreis (14) zugeordnet und in diesem Steuerkreis (14) so eingebunden ist, dass die in der jeweiligen Steuerwicklung (1b) induzierte Spannung kompensiert ist.

15. Schaltungsanordnung nach Anspruch 14, **dadurch gekennzeichnet, dass** zum Zweck der Strombegrenzung die Arbeitswicklung (1a) des Transduktors (1) als Streuinduktivität ausgebildet ist.

16. Schaltungsanordnung nach Anspruch 14, **dadurch gekennzeichnet, dass** in jedem Parallelzweig jeweils in Reihe mit der Arbeitswicklung (1a) des Transduktors (1) eine Strombegrenzungsdrossel (3) geschaltet ist.

## Claims

1. Circuit arrangement for reducing a unidirectional flux component (Φ_{DC}) in the soft-magnetic core of a transformer, comprising:
- a compensation winding (4) which is magnetically coupled to the core of the transformer;
- a transductor (1) which is connected in series with the compensation winding (4) in a compensation current path (8), wherein the compensation current path (8) has two parallel branches each containing a power winding (1a) of the transductor (1) and an uncontrolled valve (2) connected in series, wherein the flow directions of the valves (2) are counter to one another, and wherein each power winding (1a) is magnetically coupled to a control winding (1b) via a saturatable transductor core (10);
- a control device (6) to which information (12) provided by a detection device (5) about the magnitude and direction of the unidirectional flux component (Φ_{DC}) is fed on the input side, and which, on the output side, generates a control variable (11) which is fed to each control winding (1b) so that the saturation state of the transductor core (10) can be varied such that a compensation current is formed in the compensation current path (8), the effect of which counteracts the unidirectional flux component (Φ_{DC}) in the core of the transformer.

2. Circuit arrangement for compensating a unidirectional flux component (Φ_{DC}) in the soft-magnetic core of a transformer, comprising:
- a compensation winding (4) which is magnetically coupled to the core of the transformer;
- a transductor (1) having a power winding (1a) which is connected in series with the compensation winding (4) in a compensation current path (8), wherein there is disposed in the compensation current path (8) an uncontrolled valve (2) and a switching device (15) for reversing the polarity of the current flow direction in the valve (2), and wherein the power winding (1a) is magnetically coupled to a control winding (1b) via a saturatable transductor core (10);
- a control device (6) to which information (12) provided by a detection device (5) about the magnitude and direction of the unidirectional flux component (Φ_{DC}) is fed on the input side, and which, on the output side, generates a control variable (11) which is fed to each control winding (1b) so that the saturation state of the transductor core (10) can be varied such that a compensation current (I_{K}) is formed in the compensation current path (8), the effect of which counteracts the unidirectional flux component (Φ_{DC}) in the core of the transformer.

3. Circuit arrangement according to claim 1 or 2, **characterised in that** the valve or each valve (2) is implemented as a high-blocking power diode.

4. Circuit arrangement according to one of claims 1 or 2, **characterised in that** the transductor core (10) is implemented as a split strip core (10) or as a stacked (laminated) core.

5. Circuit arrangement according to claim 4, **characterised in that** the split strip or stacked core (10) is made of laminations of a magnetically soft material having an essentially narrow, rectangular hysteresis curve.

6. Circuit arrangement according to claim 4 or 5, **characterised in that** the transductor core (10) is disposed in a magnetic circuit having at least one air gap so that the remanent flux density is limited to less than or equal to 20 % of the saturation flux density.

7. Circuit arrangement according to claim 6, **characterised in that** the material is grain-oriented HiB-GOES electrical steel.

8. Circuit arrangement according to claim 7, **characterised in that** the magnetic flux in the material is carried in the rolling direction of the grain-oriented HiB-GOES electrical steel.

9. Circuit arrangement according to claim 1, **characterised in that** at least one current limiting choke (3) is connected in series between transductor (1) and compensation winding (4) in the compensation current path (8), or the power winding 1 is designed for current limiting.

10. Circuit arrangement according to one of claims 1 to 8, **characterised in that** the compensation winding (4), the transductor (1), the valves (2) and possibly the current limiting choke (3) are disposed inside an insulation- or cooling-liquid-filled tank of a transformer.

11. Circuit arrangement according to one of claims 1 to 8, **characterised in that** the phase of the voltage induced in the compensation winding (4) is obtained by means of a measuring device (7) and fed to the control device (6).

12. Circuit arrangement according to one of claims 1 to 8, **characterised in that** the information about the magnitude and direction of the unidirectional flux component (Φ_{DC}) is obtained by means of a measuring device (5) disposed on the core of the transformer.

13. Circuit arrangement according to one of claims 1 to 8, **characterised in that** information about the size and direction of the unidirectional flux component (Φ_{DC}) is obtained by means of a measuring device (5) disposed on connecting cables of the transformer.

14. Circuit arrangement according to claim 1, **characterised in that**, for each control circuit (14), a transformer (16) is provided which in each case has a primary winding and a secondary winding, wherein each primary winding is fed by the compensation winding (4), and wherein each secondary winding is assigned a control circuit (14) and is incorporated in said control circuit (14) such that the voltage induced in the respective control winding (1b) is compensated.

15. Circuit arrangement according to claim 14, **characterised in that**, for the purpose of current limiting, the power winding (1a) of the transductor (1) is implemented as a leakage inductance.

16. Circuit arrangement according to claim 14, **characterised in that**, in each parallel branch, a current limiting choke (3) is connected in series with the power winding (1a) of the transductor (1).

## Revendications

1. Agencement de circuit pour diminuer une part de flux magnétique continu (Φ_{DC}) dans le noyau magnétique doux d'un transformateur, comprenant :
- un enroulement de compensation (4) qui est couplé magnétiquement au noyau du transformateur,
- un transducteur (1) qui est disposé en série avec l'enroulement de compensation (4) dans un trajet de courant de compensation (8), dans lequel le trajet de courant de compensation (8) comprend deux branches de courant parallèles, dans lesquelles un enroulement de travail (1a) du transducteur (1) et une valve (2) non commandée sont agencés respectivement en série, le sens du flux des valves (2) étant dirigé dans le sens opposé, et dans lequel chaque enroulement de travail (1a) est couplé magnétiquement à un enroulement de commande (1b) par l'intermédiaire d'un noyau de transducteur (10) saturable,
- un dispositif de commande (6) auquel une information (12) fournie par un dispositif de détection (5) sur la grandeur et la direction de la part de flux continu (Φ_{DC}) est fournie du côté entrée, et qui produit du côté sortie une grandeur de commande (11), qui est fournie à chaque enroulement de commande (1b), de telle manière que l'état de saturation du noyau de transducteur (10) est modifiable de telle façon qu'un courant de compensation se forme dans le trajet de courant de compensation (8), dont l'effet est dirigé à l'opposé de la part du flux magnétique continu (Φ_{DC}) dans le noyau du transformateur.

2. Agencement de circuit destiné à compenser une part de flux magnétique continu (Φ_{DC}) dans le noyau magnétique doux d'un transformateur, comprenant :
- un enroulement de compensation (4) qui est couplé magnétiquement au noyau du transformateur,
- un transducteur (1) comportant un enroulement de travail (1a) qui est disposé en série avec l'enroulement de compensation (4) dans un trajet de courant de compensation (8), dans lequel une valve (2) non commandée et un dispositif de commutation (15) permettant d'inverser le sens de circulation du courant dans la valve (2) sont agencés dans le trajet de courant de compensation (8), et l'enroulement de travail (1a) est couplé magnétiquement à un enroulement de commande (1b) par l'intermédiaire d'un noyau de transducteur (10) saturable,
- un dispositif de commande (6) auquel une information (12) fournie par un dispositif de détection (5) sur la grandeur et la direction de la part de flux continu (Φ_{DC}) est fournie du côté entrée, et qui produit du côté sortie une grandeur de commande (11), qui est fournie à l'enroulement de commande (1b), de telle manière que l'état de saturation du noyau de transducteur (10) est modifiable de telle façon qu'un courant de compensation (I_{K}) se forme dans le trajet de courant de compensation (8), dont l'effet est dirigé à l'opposé de la part du flux magnétique continu (Φ_{DC}) dans le noyau du transformateur.

3. Agencement de circuit selon la revendication 1 ou 2, **caractérisé en ce que** la ou chaque valve (2) est conçue sous forme de diode de puissance à blocage haut.

4. Agencement de circuit selon la revendication 1 ou 2, **caractérisé en ce que** le noyau de transducteur (10) est conçu sous forme de noyau en bande refendue (10) ou de noyau revêtu.

5. Agencement de circuit selon la revendication 4, **caractérisé en ce que** le noyau en bande refendue (10) ou le noyau revêtu est fabriqué sous forme de lamelles de tôle d'un matériau magnétique doux, qui présente un cycle d'hystérésis essentiellement étroit et rectangulaire.

6. Agencement de circuit selon la revendication 4 ou 5, **caractérisé en ce que** le noyau de transducteur (10) est disposé dans un circuit magnétique, qui comprend au moins un entrefer, de telle sorte que la densité de flux magnétique résiduel est limitée à une quantité inférieure ou égale à 20 % de la densité du flux à saturation.

7. Agencement de circuit selon la revendication 6, **caractérisé en ce que** le matériau est une tôle magnétique à grains orientés HiB-GOES.

8. Agencement de circuit selon la revendication 7, **caractérisé en ce que** le flux magnétique est introduit dans le matériau dans la direction de laminage de la tôle magnétique à grains orientés HiB-GOES.

9. Agencement de circuit selon la revendication 1, **caractérisé en ce qu'**au moins une inductance de protection (3) est disposée dans le trajet de courant de compensation (8) en série entre le transducteur (1) et l'enroulement de compensation (4) ou l'enroulement de travail (1) est configuré de manière à limiter le courant.

10. Agencement de circuit selon l'une des revendications 1 à 8, **caractérisé en ce que** l'enroulement de compensation (4), le transducteur (1), les valves (2) et le cas échéant l'inductance de protection (3) sont disposés à l'intérieur d'une cuve d'un transformateur remplie avec un liquide isolant et de refroidissement.

11. Agencement de circuit selon l'une des revendications 1 à 8, **caractérisé en ce que** la position de phase de la tension induite dans l'enroulement de compensation (4) est détectée au moyen d'un dispositif de mesure (7) et fournie au dispositif de commande (6).

12. Agencement de circuit selon l'une des revendications 1 à 8, **caractérisé en ce que** l'information sur la grandeur et la direction de la part de flux continu (Φ_{DC}) est détectée au moyen d'un dispositif de mesure (5) disposé au niveau du noyau du transformateur.

13. Agencement de circuit selon l'une des revendications 1 à 8, **caractérisé en ce que** l'information sur la grandeur et la direction de la part de flux continu (Φ_{DC}) est détectée au moyen d'un dispositif de mesure (5) disposé sur des câbles de connexion du transformateur.

14. Agencement de circuit selon la revendication 1, **caractérisé en ce qu'**un transformateur (16) est fourni pour chaque circuit de commande (14), lequel transformateur comprend respectivement un enroulement primaire et un enroulement secondaire, dans lequel chaque enroulement primaire est alimenté par l'enroulement de compensation (4) et dans lequel chaque enroulement secondaire est associé respectivement à un circuit de commande (14) et est intégré dans ce circuit de commande (14) de telle manière que la tension induite dans l'enroulement de commande (1b) respectif est compensée.

15. Agencement de circuit selon la revendication 14, **caractérisé en ce que** l'enroulement de travail (1a) du transducteur (1) est conçu sous forme d'une inductance de fuite afin de limiter le courant.

16. Agencement de circuit selon la revendication 14, **caractérisé en ce qu'**une inductance de protection (3) est connectée en série avec l'enroulement de travail (1a) du transducteur (1) respectivement dans chaque branche parallèle.
